# EUROPEAN PATENT APPLICATION

(11) **EP 2 720 276 A2**
(43) Date of publication of application: **16.04.2014**
(21) Application number: 12796270.2
(22) Date of filing: 08.06.2012
(51) Int. Cl.: H01L 31/042, H01L 31/0749, H01L 31/18

(54) **SOLAR CELL SUBSTRATE, METHOD FOR MANUFACTURING SAME, AND SOLAR CELL USING SAME**

(30) Priority: 10.06.2011 KR 20110056130; 10.06.2011 KR 20110056131; 10.06.2011 KR 20110056132; 13.06.2011 KR 20110057115
(71) Applicant: POSCO, Kyungsangbook-do 790-300 (KR)
(72) Inventor: KIM, Kyoung-Bo, Gwangyang-si Jeollanam-do 545-711 (KR); PARK, Young-Jun, Gwangyang-si Jeollanam-do 545-711 (KR); BAEK, Je-Hoon, Gwangyang-si Jeollanam-do 545-711 (KR); KIM, Jong-Sang, Gwangyang-si Jeollanam-do 545-711 (KR); KIM, Young-Geun, Gwangyang-si Jeollanam-do 545-711 (KR)
(74) Representative: Powell, Timothy John
(86) International application number: PCT/KR2012/004572
(87) International publication number: WO 2012/169845

(57) **Abstract**

One aspect of the present invention is a solar cell substrate, comprising: a lower substrate; and a lower electrode that is formed on the upper part of said lower substrate, wherein a metal diffusion-preventing film having at least one or two or more metal layers is included between said lower substrate and said lower electrode, and if two or more metal layers are formed, the metal layers adjoining each other can be different metals. Additionally, a solar cell, which is another aspect of the present invention, comprises: a lower substrate; and a lower electrode that is formed on the upper part of said lower substrate, wherein a metal diffusion-preventing film having at least one or two or more metal layers is included between said lower substrate and said lower electrode, and if two or more metal layers are formed, the metal layers adjoining each other comprise solar cell substrates which are of different metals; p-type light absorption layers formed on said solar cell substrates; n-type buffer layers formed on said light absorption layers; transparent windows formed on said buffer layers; and upper electrodes formed on said transparent windows.

## Description

### [Technical Field]

The present invention relates to a CI(G)S solar cell substrate, a method for manufacturing the solar cell substrate, and a solar cell including the solar cell substrate.

### [Background Art]

Due to the influence of global warming, fuel resource depletion, environmental pollution, or the like, a traditional method of generating energy using fossil fuels is slowly reaching its limits. In particular, although remaining quantities of petroleum predicted by experts are slightly different, the prevailing forecast is that petroleum will be depleted within a relatively short period of time.

Further, according to the convention on energy use and climate change, represented by the Kyoto Protocol, it is compulsorily required that the generation of carbon dioxide produced by the combustion of fossil fuels should be decreased. Therefore, it is clear that the continued use of fossil fuels will have effect on all countries in the world, as well as current treaty powers, so that going into the future, restrictions will be set on annual consumption amounts of fossil fuels.

Representative energy sources mostly used as substitutes for fossil fuels may include nuclear power. Nuclear power generation has been in the spotlight as an influential alternative energy source which can replace fossil fuels such as petroleum and is available in an almost infinite quantity, since the amount of energy that can be generated per unit weight of uranium or plutonium as raw material is large, and greenhouse gases such as carbon dioxide are not generated in the case of nuclear power generation.

However, nuclear meltdowns such as that which occurred at a nuclear power plant in Chernobyl in the former Soviet Union or the meltdowns which occurred at the Fukushima nuclear power plant in Japan due to the Great East Japan Earthquake (the 2011 To̅haku Earthquake) have been served to build momentum for reexamining the safety of nuclear power generation, a source of power that had been regarded, in some quarters, as a potentially clean energy source available in an infinite quantity. As a result thereof, it is more urgently needed than ever to introduce alternative sources of energy, other than nuclear power.

Although certain alternative energy sources, such as hydroelectric power, have often been as touted as alternatives to fossil fuels, their uses may be limited because the hydroelectric power generation is greatly influenced by topographic factors and climatic factors. Further, it is also difficult to use alternative energy sources as alternatives to fossil fuels, due to the fact that alternative energy sources generate relatively small amounts of power, or have greatly limited areas of application.

However, solar cells have the advantage that it is possible to produce electric power by installing solar cell panels on small rooftop and other building areas when solar cells are provided in answer to demand for low capacity solar cells for household use, since such solar cells not only usable anywhere, but are also almost linearly proportional to each other in terms of electric power generating capacity and facility scale, if a proper amount of sunshine is guaranteed. Therefore, the use of the solar cells has increased all over the world, and studies related to solar cells have also increased.

In solar cells using the principle of semiconductors, electron hole pairs (EHP) are produced by irradiating light having at least a certain level of energy onto p-n junction semiconductors such that valence electrons in the semiconductors are excited to be freely movable valence electrons. The electron hole pairs thusly produced are moved to electrodes that are placed opposite to each other to generate electromotive force.

The most basic form of the solar cell is a silicon-based solar cell, commonly known as a first generation solar cell, wherein the silicon-based solar cell is formed by doping an impurity B on a silicon substrate to form a p-type semiconductor, doping another impurity P on a p-type semiconductor to form a layer, and forming a part of the layer into an n-type semiconductor such that p-n junction is performed.

Such a silicon-based solar cell has the highest degree of commercialization due to its relatively high energy conversion efficiency and cell conversion efficiency (a ratio of conversion efficiency during mass-production to the highest energy conversion efficiency in the laboratory). However, there is a problem, in that in the manufacturing thereof, material consumption is relatively high, resulting in high manufacturing costs, since in the manufacturing of a module for the silicon-based solar cell, such a module not only passes through somewhat complicated process steps of first manufacturing an ingot from a particular material, forming the ingot into a wafer to manufacture cells and modeling the cells, but also includes using a bulk type material.

In order to resolve such shortcomings of the silicon-based solar cell as described above, a so-called thin film type solar cell commonly known as a second generation solar cell has been suggested. Such a thin film type solar cell has an advantage in that material costs in the manufacturing thereof are relatively inexpensive due to a simple manufacturing process and the relative thinness of the thin film type solar cell, since the solar cell is not manufactured by the above-mentioned process, but it is manufactured in such a form that required thin film layers are stacked in sequence on the substrate.

There are many obstacles to the commercialization of such a thin film type solar cell, since it does not yet have a high degree of energy conversion efficiency, as compared to existing silicon-based solar cells, in numerous cases. However, some thin film type solar cells having high energy conversion efficiency have been developed and are in the process of being commercialized.

One of the solar cells having high energy conversion efficiency is, for example, a CI(G)S-based solar cell, wherein the solar cell is based on a CI(G)S compound semiconductor including copper (Cu), indium (In), germanium (Ge), and selenium (Se), wherein the solar cell may not include germanium, and the solar cell may be referred to as a CIS compound semiconductor if germanium is not contained in the solar cell.

The above-described solar cell has an advantage that it can increase energy conversion efficiency by controlling contents of the elements such that widths of band gaps can be controlled, since the semiconductor includes three or four elements. Sometimes, selenium (Se) may be substituted for sulfur (S), and selenium (Se) may be used together with sulfur (S). Such solar cells in both the cases are regarded as CI(G)S solar cells in both cases.

A CIGS solar cell including germanium has a lower substrate existing in the lowermost layer thereof, and a lower electrode used as an electrode is formed on the lower substrate. A structure including the lower substrate and the lower electrode is typically referred to as a solar cell substrate. A light absorbing layer, e.g., CIGS as a p-type semiconductor, a buffer layer, e.g., CdS as an n-type semiconductor, a transparent window, and an upper electrode are subsequently formed on the lower electrode.

Glass has been popularly used as the material forming the lower substrate. Glass contains Na, and Na has been known to play a role in increasing open circuit voltage and fidelity of the solar cell because Na diffuses into a CIGS layer. However, although a proper amount of Na may improve efficiency of a solar cell, there may be a problem in that efficiency of the solar cell may be somewhat deteriorated if Na is excessively diffused into the CIGS layer.

A number of attempts have recently been made to use a flexible substrate instead of a glass substrate which is expensive and mass-produced, and can only be used in a standardized form. The flexible substrate is applicable to diverse applications such as Building Integrated Photovoltaics (BIPV) and aerospace solar cells, since the flexible substrate is more inexpensive than glass and enables the solar cell to be manufactured by a roll-to-roll process and also to have various shapes. Examples of such flexible substrate may mainly include metal sheets or plastic-based substrates such as stainless steel, aluminum foil, and polyimide films. Since such a flexible substrate has a relatively large amount of impurities in addition to Fe and the impurities diffuse into the lower electrode or the CIGS layer, there is a problem of deteriorating efficiency of the solar cell.

A technology of forming a diffusion barrier layer consisting of a single layer has been typically applied in order to suppress excessive diffusion of Na and inhibit impurity diffusion in such a flexible substrate when a glass substrate is used.

However, the diffusion barrier layer should be significantly reduced in thickness to meet requirements such as film-thinning and weight-lightening of the solar cell, thereby leading to a new problem that an effective diffusion preventing effect is unable to be secured in the case of the diffusion barrier layer consisting of the single layer.

Further, there is a case in which the addition of Na is needed, since Na plays a role in improving solar cell performance. However, diffusion of Na is inhibited due to the diffusion barrier layer, and thus a technology of supplementing inhibition of Na diffusion is demanded.

### [Disclosure]

### [Technical Problem]

An aspect of the present invention provides a solar cell substrate of inhibiting impurities from being diffused from a lower substrate thereof and improving solar cell efficiency, a method for manufacturing the solar cell substrate, and a solar cell including the solar cell substrate.

### [Technical Solution]

According to an aspect of the present invention, there is provided a solar cell substrate including a lower substrate, a lower electrode formed on top of the lower substrate, and a metal diffusion barrier layer consisting of one or more metal layers between the lower substrate and the lower electrode, wherein the metal layers brought into contact with each other may be different metals in the case that the metal diffusion barrier layer consists of two or more metal layers.

According to another aspect of the present invention, there is provided a solar cell including: a solar cell substrate including a lower substrate, a lower electrode formed on top of the lower substrate, and a metal diffusion barrier layer consisting of one or more metal layers formed between the lower substrate and the lower electrode, wherein the metal layers brought into contact with each other may be different metals in the case that the metal diffusion barrier layer consists of two or more metal layers; a p-type light absorbing layer formed on the solar cell substrate; an n-type buffer layer formed on the light absorbing layer; a transparent window formed on the buffer layer; and an upper electrode formed on the transparent window.

According to another aspect of the present invention, there is provided a method for manufacturing a solar cell substrate including: dispersing Na-containing metal particles into an electrolyte for electroplating; and preparing a diffusion barrier layer by electroplating the electrolyte into which the Na-containing metal particles have been dispersed onto the lower substrate, thereby forming a metal layer including Na on the lower substrate.

### [Advantageous Effects]

According to the present invention, it is possible to effectively inhibit diffusion of impurities such as Na and Fe contained in a lower substrate. In particular, the diffusion barrier layer consisting of two or more layers is capable of obtaining superior diffusion preventing effects compared to a single layer with the same thickness by virtue of interfaces between the two or more layers. In addition, according to the present invention, it can be expected that superior diffusion preventing effects are achieved due to a mixed structure in which a metal layer and an amorphous oxide layer are alternately stacked as well as due to interface effects resulting from a multilayered structure of two or more layers.

Furthermore, the present invention provides effects of improving solar cell performance by adding Na contained in the diffusion preventing layer to a solar cell semiconductor layer via the lower electrode.

Moreover, the present invention is advantageous in that Na that can improve the performance of the solar cell can be easily contained at the same time when the diffusion barrier layer is formed, and also advantageous in that the performance of the solar cell can be improved without additionally doping Na or requiring an additional treatment.

### [Description of Drawings]

The above and other aspects, features and other advantages of the present invention will be more clearly understood from the following detailed description taken in conjunction with the accompanying drawings, in which:
FIG. 1 is a cross-sectional view showing an embodiment of a solar cell substrate of the present invention;
FIG. 2 is a cross-sectional view showing an embodiment of a solar cell substrate of the present invention;
FIG. 3 is a cross-sectional view showing an embodiment of a solar cell substrate of the present invention;
FIG. 4 is a cross-sectional view showing an embodiment of a solar cell substrate of the present invention;
FIG. 5 is a cross-sectional view showing an embodiment of a solar cell substrate of the present invention;
FIG. 6 is a cross-sectional view showing an embodiment of a solar cell substrate of the present invention;
FIG. 7 is a cross-sectional view showing a portion of an embodiment of a solar cell of the present invention;
FIG. 8 is a cross-sectional view showing a portion of an embodiment of a solar cell of the present invention;
FIG. 9 is a cross-sectional view showing a portion of an embodiment of a solar cell of the present invention;
FIG. 10 is a graph illustrating analysis results of components from Example 1 to Comparative Example 1;
FIG. 11 is a graph illustrating analysis results of components from Example 1 to Inventive Example 1;
FIG. 12 is a graph illustrating analysis results of components from Example 2 to Comparative Example 2;
FIG. 13 is a graph illustrating analysis results of components from Example 2 to Inventive Example 2.

### [Mode for Invention]

Exemplary embodiments of the present invention will now be described in detail with reference to the accompanying drawings.

A solar cell substrate of the present invention includes a lower substrate, a lower electrode formed on top of the lower substrate, and a metal diffusion barrier layer consisting of one or more metal layers, wherein the metal layers brought into contact with each other may be different metals in the case that the metal diffusion barrier layer consists of two or more metal layers. In the present invention, the solar cell substrate is distinguished from the lower substrate and may include the diffusion barrier layer and the lower electrode as well as the lower substrate.

The diffusion barrier layer formed between the lower substrate and the lower electrode of the solar cell, is preferably formed of two or more metal layers, and is more preferably formed of three or more metal layers.

The diffusion barrier layer is formed of two or more metal layers on the solar cell substrate of the present invention to prevent impurities such as Na and Fe from being diffused and particularly to maximize effects of inhibiting diffusion of the impurities by interfaces of the two or more metal layers.

In other words, a multilayered metal diffusion barrier layer formed of the above-mentioned two or more metal layers functions as a barrier when diffusing the impurities such as Na and Fe from an interface formed between different types of materials. Namely, the impurities are affected by a barrier of diffusion due to a diffusion behavioral difference between the new metal layer and an existing metal layer when the impurities that have been diffused into identical metal layers encounter a new metal layer. Due to such an interface effect or a barrier effect, the diffusion barrier layer of a multilayered structure is capable of maximizing an effect of inhibiting diffusion of the impurities.

Further, the present invention is capable of securing far superior diffusion preventing effect compared to the single layer although multiple layers as the diffusion barrier layer are formed to the same thickness as a single layer through the diffusion preventing effect by the metal layer interface. For example, when comparing a diffusion barrier layer formed of a single layer of 150 nm with a multilayered diffusion barrier layer formed of three 50 nm layers, the multilayered diffusion barrier layer may have a diffusion preventing effect that is more excellent than that of the single-layered diffusion barrier layer even at the same thickness since the multilayered diffusion barrier layer additionally has two or more interfaces compared to a single-layered diffusion barrier layer.

It is preferable that interfaces of the metal layers brought into contact with each other are formed of different types of materials in the two or more metal layers, and it is more preferable that the two or more metal layers are formed of different types of metallic materials. Metals such as Cr, Ni, Ti, and Mo may be applied to the metal layers.

The diffusion barrier layer preferably has an overall thickness of 100 to 500 nm. It is preferable to secure a thickness of 100 nm or more to secure a role as the diffusion barrier layer, and it is preferable that the thickness does not exceed 500 nm since it is difficult to expect an increase in the diffusion preventing effect compared to the thickness if the diffusion barrier layer preferably has a thickness of more than 500 nm.

Meanwhile, although thickness of each of the respective metal layers forming the multilayered metal diffusion barrier layer is not particularly limited, it is preferable that each of the respective metal layers has a thickness of at least 10 nm such that the metal layers as different types of metals secure the interface effect for preventing the diffusion.

Methods for forming metal layers forming the diffusion barrier layer are not particularly limited in the present invention, and various methods such as sputtering, evaporation, and metal electroplating may be applied as the methods.

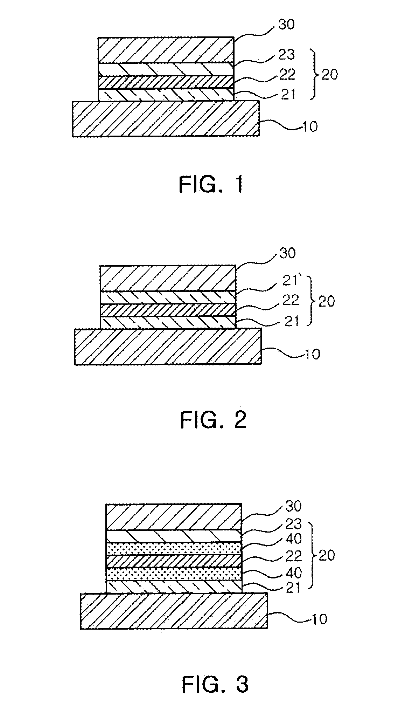

Hereinafter, exemplary embodiments of a solar cell substrate of the present invention will now be described in detail with reference to FIGS. 1 and 2. The FIGS. 1 and 2 represent only embodiments of the present invention, but the present invention should not be construed as limited thereto.

FIG. 1 is a drawing showing a cross-sectional view of a solar cell substrate including a multilayered metal diffusion barrier layer 20 formed of a total of three metal layers 21, 22 and 23 between a lower substrate 10 and a lower electrode 30. FIG. 1 shows that the respective metal layers 21, 22 and 23 forming the diffusion barrier layer are formed of materials that are different from each other. For instance, a first metal layer 21, a second metal layer 22 and a third metal layer 23 are formed of Cr, Ni and Ti respectively such that the multilayered metal diffusion barrier layer is formed of metal materials that are different from each other.

FIG. 2, as in FIG. 1, is a drawing showing a cross-sectional view of a solar cell substrate including a multilayered metal diffusion barrier layer 20 formed of a total of three metal layers between a lower substrate 10 and a lower electrode 30. A difference between FIGS. 1 and 2 represents that the first metal layer 21 and the second metal layer 22 are materials that are different from each other, but the first metal layer 21 and a third metal layer 21' are formed of the same material. For instance, FIG. 2 shows a solar cell substrate in which the first metal layer 21, the second metal layer 22 and the third metal layer 21' are formed of Ni, Ti and Ni respectively such that the multilayered metal diffusion barrier layer is formed in a sandwich form.

Further, if the diffusion barrier layer is formed of two or more metal layers, the diffusion barrier layer may additionally include one or more oxide layers. That is, the multilayered diffusion barrier layer preferably has a structure in which the metal layers are formed together with amorphous oxide layers. Combined layers of the metal layers and the oxide layers are stacked in the diffusion barrier layer to inhibit diffusion of impurities such as Na and Fe of the lower substrate. This not only obtains an interface effect in which diffusion of the impurities is inhibited by interfaces formed between layers, but also obtains an effect of further inhibiting diffusion of such metals as Na and Fe due to existence of amorphous oxide layers instead of metals.

In other words, the multilayered diffusion barrier layer included in a solar cell substrate of the present invention is capable of obtaining a diffusion preventing effect due to the interface by forming the metal layers together with the oxide layers such that the multilayered diffusion barrier layer functions as a barrier for blocking diffusion of impurities such as Na and Fe at an interface formed between different types of materials. Further, the diffusion preventing effect can be additionally increased since crystalline metals and amorphous oxides due to their micro-structural differences make it additionally difficult to move the impurities through the amorphous oxides after moving such impurities in the metals.

Such a diffusion barrier layer including the metal layers and the oxide layers is capable of securing a far excellent diffusion preventing effect compared to the single layer although the diffusion barrier layer is formed to the same thickness as a single layer. For example, both of the diffusion barrier layers may have more excellent diffusion preventing effects even at the same thickness since a diffusion barrier layer formed of a single layer of 150 nm and a diffusion barrier layer formed of metal, oxide and metal layers each having a thickness of 50 nm additionally have two or more interfaces compared to the diffusion barrier layer formed of the single layer and include amorphous oxide layers.

The multilayered diffusion barrier layer preferably includes two or more metal layers and one or more oxide layers which are stacked alternately to each other. For instance, if the multilayered diffusion barrier layer includes two metal layers and an oxide layer, a multilayered diffusion barrier layer in which metal, oxide and metal are sequentially stacked is capable of further maximizing the diffusion preventing effect compared to a multilayered diffusion barrier layer in which metal, metal and oxide are sequentially stacked.

The reason is that metal and oxide are crystalline and amorphous respectively and thus do not have continuity at all while metal and metal are all crystalline and thus have continuity.

Metals such as Cr, Ni, Ti, and Mo may be applied to the metal layers, and examples of the oxide may include silicon oxides (SiOx), silicon nitrides (SiNx), and alumina (Al₂O₃).

On the other hand, although thicknesses of the respective metal layers and oxide layer are not particularly limited, the metal layers and the oxide layer preferably have thicknesses of at least 10 nm to secure diffusion preventing effects.

Methods for forming metal layers forming the diffusion barrier layer are not particularly limited in the present invention, and various methods such as sputtering, evaporation, and metal electroplating may be applied as the methods here as well. Further, methods for forming an oxide layer are also not particularly limited, and the oxide layer is formed by various methods such as a sol-gel method, and tape casting.

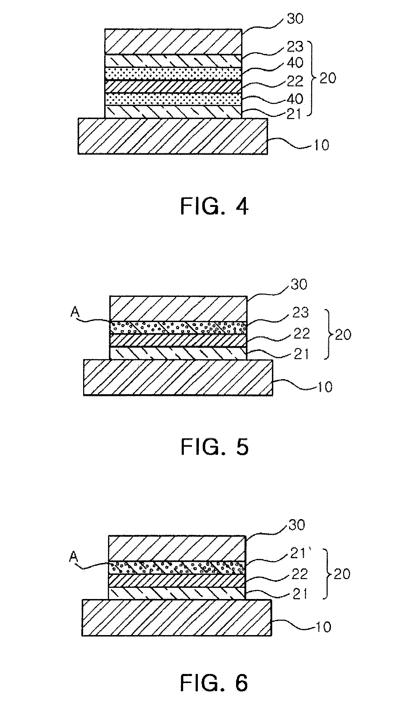

Furthermore, exemplary embodiments of a solar cell substrate of the present invention will now be described in detail with reference to FIGS. 3 and 4. The FIGS. 3 and 4 represent only embodiments of the present invention, but the present invention should not be construed as limited thereto.

FIG. 3 shows a cross-sectional view of a solar cell substrate including a diffusion barrier layer 20 which is formed between a lower substrate 10 and a lower electrode 30 and consists of totally three metal layers 21, 22 and 23 and two oxide layers 40. FIG. 3 illustrates that respective diffusion preventing metal layers 21, 22 and 23 are formed of materials that are different from each other, and the three metal layers and two oxide layers are formed in such a manner that they are stacked alternately with each other. For instance, FIG. 3 illustrates that, if a first metal layer 21 is formed of Cr, a second metal layer 22 and a third metal layer 23 are formed of Ni and Ti respectively, and an oxide layer 40 formed of SiO₂ is formed between the first metal layer 21 and the second metal layer 22 and between the second metal layer 22 and the third metal layer 23.

Although FIG. 4 has a form that is the same as that of FIG. 3, FIG. 4 is different from FIG. 3 in that a first metal layer 21 and a third metal layer 21' of FIG. 4 are formed of materials that are identical to each other.

In addition, it is preferable that one or more metal layers in two or more metal layers of the solar cell substrate include Na. It is more preferable that the diffusion barrier layer formed of a metal layer includes Na. The metal layers including Na are preferably metal layers adjacent to the lower electrode.

The Na contained in the metal layers is diffused into the lower electrode and the solar cell semiconductor to improve performance of the solar cell by playing a role in increasing open circuit voltage and fidelity of the solar cell.

The Na may be formed of the metal layers by a method of doping Na on the metal layers through Cu-sputtering or a method of forming metal layers containing Na using Na-containing metal, and the method of forming the metal layers is not limited thereto.

Preferred methods for doping Na may include a method of sputtering soda lime glass with a target and a method of evaporation-depositing a NaF precursor.

Any one of the metal layers preferably includes 0.0005 to 0.1% by weight of Na. It is difficult to expect an open circuit voltage-improving effect of the solar cell due to addition of Na since diffusion of Na hardly influences a CIGS solar cell at a very small Na content of less than 5 ppm. It is difficult to expect an additional solar cell performance-improving effect due to addition of Na if the Na content exceeds 0.1% by weight of Na. Therefore, it is preferable to contain less than 0.1% by weight of Na considering economic efficiency.

Furthermore, exemplary embodiments of a solar cell substrate of the present invention will now be described in detail with reference to FIGS. 5 and 6. The FIGS. 5 and 6 represent only embodiments of the present invention, but the present invention should not be construed as being limited thereto.

FIG. 5 shows a cross-sectional view of a solar cell substrate including a multilayered metal diffusion barrier layer 20 formed of a total of three metal layers 21, 22 and 23 between a lower substrate 10 and a lower electrode 30, wherein the metal layer 23 brought into contact with the lower electrode 30 among the metal layers includes Na(A). FIG. 5 illustrates that respective diffusion preventing metal layers 21, 22 and 23 are formed of materials that are different from each other. For instance, the multilayered metal diffusion barrier layer is formed of metal materials that are different from each other by forming a second metal layer 22 and a third metal layer 23 of Ni and Ti respectively if a first metal layer 21 is formed of Cr.

FIG. 6, as in FIG. 5, is a drawing showing a cross-sectional view of a solar cell substrate including a multilayered metal diffusion barrier layer 20 formed as a total of three metal layers between a lower substrate 10 and a lower electrode 30. A difference between FIGS. 5 and 6 represents that the first metal layer 21 and the second metal layer 22 are materials that are different from each other, but the first metal layer 21 and a third metal layer 21' are formed of the same material, and the third metal layer 21' includes sodium A. For instance, FIG. 6 shows that the first metal layer 21, the second metal layer 22 and the third metal layer 21' are formed of Ni, Ti and Ni respectively, such that the multilayered metal diffusion barrier layer is formed in a sandwich form.

Further, flexible substrates as well as glass may be applied as materials for the lower substrate. Examples of the flexible substrates may include metallic materials such as stainless steel, aluminum foil, Fe-Ni based metal sheets and Fe-Cu based metal sheets, plastic-based materials such as polyimide.

Hereinafter, a solar cell of the present invention will be described in detail.

A solar cell of the present invention includes a solar cell substrate including the metal diffusion barrier layer. That is, the present invention includes: a solar cell substrate including a lower substrate, a lower electrode formed on top of the lower substrate, and a metal diffusion barrier layer consisting of one or more metal layers formed between the lower substrate and the lower electrode, wherein the metal layers brought into contact with each other may be different metals in the case that the metal diffusion barrier layer consists of two or more metal layers; a p-type light absorbing layer formed on the solar cell substrate; an n-type buffer layer formed on the light absorbing layer; a transparent window formed on the buffer layer; and an upper electrode formed on the transparent window.

Materials for the light absorbing layer, the buffer layer and the like may be varied according to types of a solar cell to be embodied. For instance, a CIGS solar cell includes a light absorbing layer formed of CIGS, a buffer layer as an n-type semiconductor formed of CdS, and a transparent window formed of ZnO.

On the other hand, flexible substrates as well as glass may be applied as materials for the lower substrate. Examples of the flexible substrates may include metallic materials such as stainless steel, aluminum foil, Fe-Ni based metal sheets and Fe-Cu based metal sheets, plastic-based materials such as polyimide.

Examples of the metal layers forming the multilayered metal diffusion barrier layer may include Cr, Ni, and Ti.

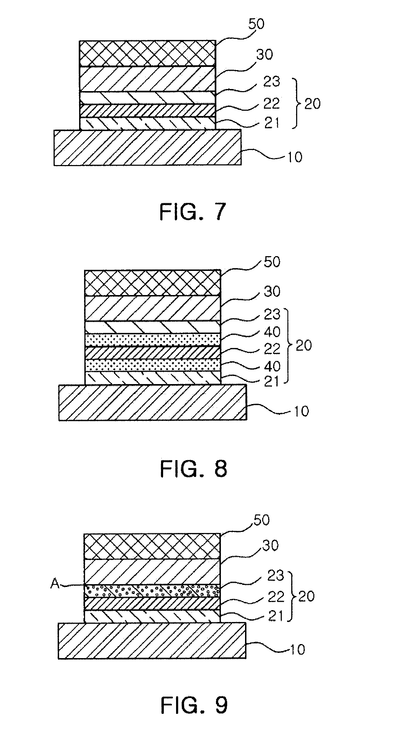

Hereinafter, a part of a solar cell as an exemplary embodiment of the present invention was illustrated in FIG. 7. FIG. 7 illustrates only an exemplary embodiment of the present invention, but the present invention is not necessarily limited thereto. FIG. 7 illustrates a part of a solar cell including a multilayered metal diffusion barrier layer 20 formed on a lower substrate 10, a lower electrode 30 formed on the multilayered metal diffusion barrier layer 20, and a light absorbing layer 50 formed on the lower electrode 30.

In addition, the diffusion barrier layer may additionally include an oxide layer, and it is most preferable that the diffusion barrier layer is formed in such a manner that two or more metal layers and an oxide layer are stacked alternately to each other, wherein the oxide layer is preferably any one of SiOx, SiNx and Al₂O₃. Contents regarding the oxide layer are the same as those described in the above-mentioned solar cell substrate.

Further, a part of an exemplary embodiment of a solar cell according to the present invention was illustrated in FIG. 8. FIG. 8 illustrates only an exemplary embodiment of the present invention, but the present invention is not necessarily limited thereto. FIG. 8 illustrates an embodiment of a solar cell including a diffusion barrier layer 20 of a multilayered structure in which an oxide layer 40 is formed on a lower substrate 10, and a lower electrode 30 and a light absorbing layer 50 which are formed on the diffusion barrier layer 20.

As described above, it is preferable that the diffusion barrier layer includes one or more metal layers containing Na. Contents regarding each of the metal layers are the same as those described in the above-mentioned solar cell substrate.

Hereinafter, a part of an exemplary embodiment of a solar cell according to the present invention was illustrated in FIG. 9. FIG. 9 illustrates only an exemplary embodiment of the present invention, but the present invention is not necessarily limited thereto. FIG. 9 illustrates a part of a solar cell including a metal diffusion barrier layer 20 containing Na (A) which is formed on a lower substrate 10, a lower electrode 30 formed on the diffusion barrier layer 20, and a light absorbing layer 40 formed on the lower electrode 30.

Hereinafter, a manufacturing method of a solar cell substrate as another exemplary embodiment of the present invention is described. The manufacturing method to be described here relates to a method of simultaneously performing doping of Na while forming a diffusion barrier layer between a lower substrate and a lower electrode of the solar cell. Such a manufacturing method is concerned with an exemplary embodiment of the present invention, but the present invention is not limited to the above-mentioned manufacturing method of the solar cell substrate.

A method of preparing a diffusion barrier layer by electroplating metal on a lower substrate of a solar cell is used in the present invention.

The method includes dispersing Na-containing metal particles into an electrolyte for electroplating, performing electroplating on the lower substrate using an electrolyte in which the Na-containing metal particles have been dispersed, and preparing a diffusion barrier layer in which metal layers containing Na are formed.

A method of preparing a diffusion barrier layer by performing electroplating on a lower substrate of a solar cell, thereby forming a metal layer according to the present invention includes dispersing Na-containing metal particles into an electrolyte for electroplating. When the Na-containing metal particles are dispersed into the electrolyte and when electroplating is carried out using such an electrolyte, plating is conducted by adhering the Na dispersed into the electrolyte together with metal forming the metal layer to the lower substrate. This method according to the present invention has an advantage of simply preparing a diffusion barrier layer containing Na through a single plating process.

Types of the metal particles containing dispersed Na are not particularly limited; it is enough that Na is capable of being dispersed in the form of particles that are insoluble into an electroplating bath. Preferable examples of the Na-containing metal particles may include sodium oxide (NaO2) nanoparticles. The Na-containing metal particles are advantageously formed to have a round shape, the Na-containing metal particles having a particle diameter of 10 to 100 nm may be used, and the Na-containing metal particles preferably have a particle diameter of 10 to 50 nm.

Meanwhile, although dispersion plating is possible at a sodium oxide particle concentration of 0.1 to 100 g/L in case of using sodium oxides, the sodium oxide particle concentration is preferably 1 to 50 g/L, and more preferably 5 to 50 g/L.

Dispersants may be used to prevent sodium oxides as solid particles from settling down during dispersion plating.

Examples of metals for electroplating may include Cr, Ni, and Ti.

The electrolyte into which the Na-containing metal particles are dispersed is used to form the diffusion barrier layer of the metal layer on the lower substrate of the solar cell, wherein the formed metal layer contains Na. The electroplating is performed by an ordinary electroplating method, and it is not particularly limited.

A specific example of electroplating that is applicable to the present invention includes heating pure water to a temperature of 50 to 60 °C, dissolving metal salts (mainly sulfates) of Cr, Ni, and Ti as the metals to be plated such that a metal ion concentration of 1 to 100 g/L is obtained, and adding sodium oxide particles to the dissolved metal salts. The specific example of electroplating further includes controlling pH of the solution to a range of 1 to 6 using about 5% sulfuric acid as a diluted sulfuric acid solution to prepare a plating bath, and performing plating by applying a current density of 0.1 to 100 A/dm2 to a cathode for plating using iridium oxide (IrO2)-coated titanium plate as an insoluble anode. The plating time varies depending on thickness of the coating layer.

The above-mentioned method corresponds to a method that is capable of realizing the embodiment of the solar cell substrate, and it is possible to appropriately change the method depending on a form of the solar cell substrate to be realized.

Hereinafter, the present invention will be described in more detail with reference to the following examples. However, the following examples are provided for illustrative purposes only, and the scope of the present invention should not be construed as being limited thereto in any manner. This is because the right scope of the present invention is determined by claims and contents which are reasonably inferred from the claims.

### (Example 1)

In order to check an effect of preventing diffusion of a solar cell substrate having a multilayered metal diffusion barrier layer, a stainless steel (STS 430) lower substrate was prepared, and Cr was deposited on the stainless steel lower substrate to a thickness of 100 nm to form a diffusion barrier layer as Comparative Example 1. Further, Mo was deposited on the stainless steel lower substrate to a thickness of 10 nm under the same conditions as those in the Comparative Example 1, and Cr was deposited again on the deposited Mo on the stainless steel lower substrate to form a metal diffusion barrier layer formed of double layers of Mo/Cr as Inventive Example 1.

The deposition was conducted by a sputtering method, and the deposition was carried out by applying power of 1200 W to a target under conditions of a pressure of 7 mTorr and a flow rate of Ar 10 sccm.

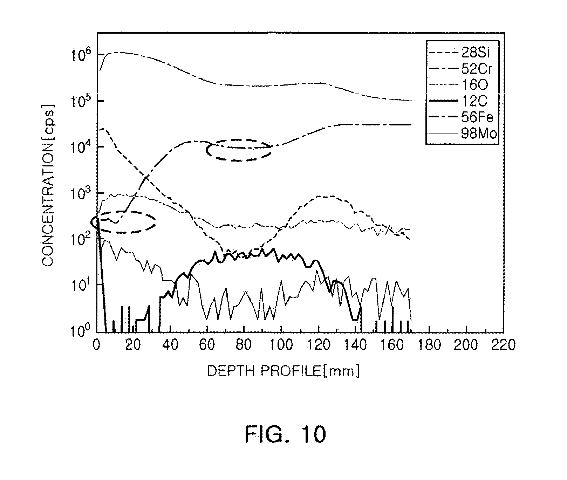

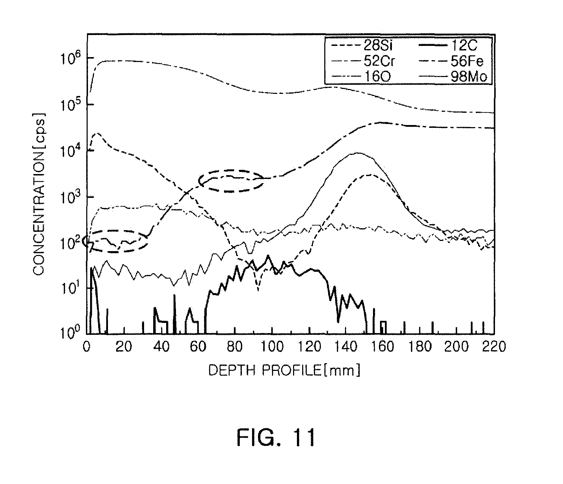

Observation results were illustrated in FIGS. 10 and 11 respectively after heat-treating the prepared diffusion barrier layers of the Comparative Example 1 and the Inventive Example 1 at conditions of 600 °C and 20 minutes that are similar to operating conditions of a fuel cell, observing to which extent Fe on the stainless steel lower substrate had been diffused, thereby observing the diffusion preventing effects of the Comparative Example 1 and the Inventive Example 1.

FIG. 10 is a graph observing the concentration of atoms in the depth direction from the surface of the diffusion barrier layer of the Comparative Example 1. It could be confirmed that the diffusion barrier layer of the Inventive Example 1 had about 50% or more of a diffusion prevention-improving effect compared to that of the Comparative Example 1 since Fe concentrations on the surface and in the depth of 60 nm of the diffusion barrier layer of the Inventive Example 1 were observed to be about 6*101 cps and about 3*103 cps respectively in FIG. 5 although it could be confirmed that Fe concentrations on the surface and in the depth of 60 nm of the diffusion barrier layer of the Comparative Example 1 were observed to be about 3*102 cps and about 1.5*104 cps respectively in FIG. 10.

Therefore, it could be confirmed that a solar cell substrate including a multilayered metal diffusion barrier layer prepared by forming two or more metal layers as in the present invention has an excellent diffusion preventing effect compared to a solar cell substrate including a diffusion barrier layer formed of a single metal layer of the prior art.

### (Example 2)

In order to confirm a diffusion preventing effect of a multilayered structure, a diffusion barrier layer was formed by depositing SiO₂ to a thickness of 1000 nm on the stainless steel substrate using a substrate made of stainless steel (STS 430 material) as Comparative Example 2. Further, Mo was deposited on the stainless steel substrate to a thickness of 60 nm under the same conditions as those in the Comparative Example 2, and SiO₂ was deposited on the deposited Mo of the stainless steel substrate to a thickness of 1000 nm to form a diffusion barrier layer formed of double layers of SiO₂/Mo as Inventive Example 2.

The deposition process of SiO₂ was executed by a PECVD method, wherein the SiO₂ was deposited by applying a power of 200 W and maintaining flow rates of N₂O 600 sccm, SiH4 45 sccm and Ar 700 sccm under a pressure of 800 mTorr. The Mo was deposited by applying a power of 1200 W and maintaining a flow rate of Ar 10 sccm under a pressure of 7 mTorr.

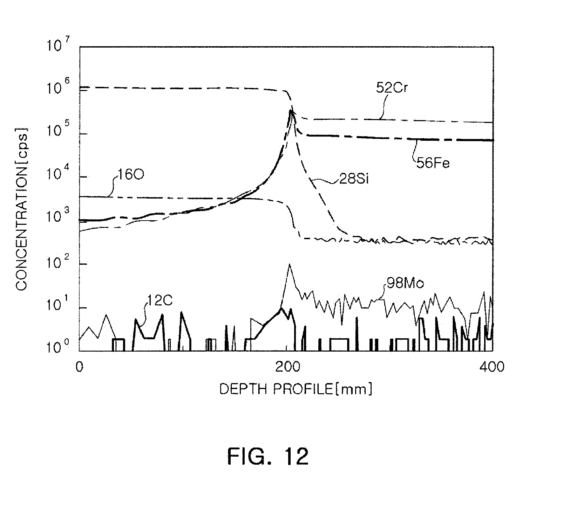

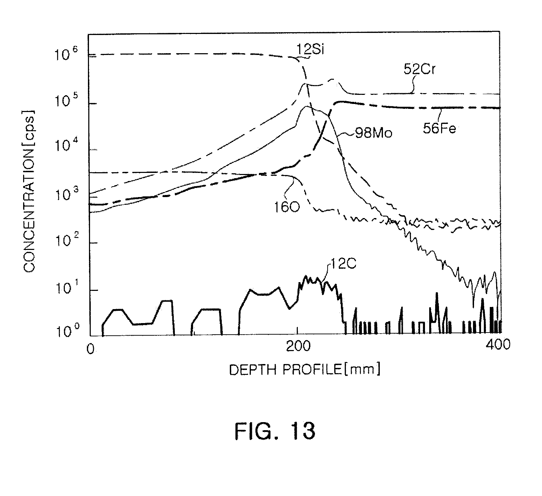

Observation results were illustrated in FIGS. 12 and 13 respectively after heat-treating the prepared diffusion barrier layers of the Comparative Example 2 and the Inventive Example 2 at conditions of 600 °C and 20 minutes that are similar to operating conditions of a fuel cell, observing to which extent Fe on the stainless steel substrate had been diffused, thereby observing the diffusion preventing effects of the Comparative Example 2 and the Inventive Example 2.

FIG. 12 is a graph observing the concentration of atoms in the depth direction from the surface of the diffusion barrier layer of the Comparative Example 2. It could be confirmed that the diffusion barrier layer of the Inventive Example 2 had about 30% or more of a diffusion prevention-improving effect compared to that of the Comparative Example 2 since Fe concentrations on the surface of the diffusion barrier layer of the Inventive Example 2 was observed to be about 7*102 cps in FIG. 13 although it could be confirmed that Fe concentrations on the surface of the diffusion barrier layer of the Comparative Example 2 was observed to be about 1*103 cps in FIG. 12.

Therefore, it could be confirmed that a diffusion barrier layer in which metal layers are formed together with an oxide layer as in the present invention has an excellent diffusion preventing effect compared to a diffusion barrier layer in which a single oxide layer is formed.

### (Example 3)

In order to confirm a diffusion preventing effect of a multilayered structure including an oxide layer, photo-conversion efficiency of a solar cell according to whether the oxide layer had been formed or not was measured. An ordinary sodalime glass substrate was applied in Comparative Example 3. A diffusion barrier layer was formed in Comparative Example 4 by preparing a substrate made of stainless steel (STS 430 material) and depositing SiO₂ to a thickness of 1000 nm on the stainless steel substrate. Further, a diffusion barrier layer consisting of double layers of SiO₂/Mo was formed in Inventive Example 3 by depositing Mo to a thickness of 20 nm on a stainless steel substrate under the same conditions as those in the above-mentioned stainless steel substrates and depositing SiO₂ to a thickness of 500 nm on the deposited Mo of the stainless steel substrate. In addition, a diffusion barrier layer consisting of quadruple layers of SiO₂/Mo/SiO₂/Mo was formed in Inventive Example 4 by depositing Mo to a thickness of 100 nm on a stainless steel substrate under the same conditions as those in the above-mentioned stainless steel substrates, depositing SiO₂ to a thickness of 200 nm on the deposited Mo of the stainless steel substrate, depositing again Mo to a thickness of 100 nm on the deposited SiO₂, and depositing again SiO₂ to a thickness of 200 nm on the deposited Mo.

The deposition process of SiO₂ was executed by a PECVD method, wherein the SiO₂ was deposited by applying a power of 200 W and maintaining flow rates of N₂O 600 sccm, SiH4 45 sccm and Ar 700 sccm under a pressure of 800 mTorr. The Mo was deposited by applying a power of 1200 W and maintaining a flow rate of Ar 10 sccm under a pressure of 7 mTorr.

Measurement results were represented in the following Table 1 after performing tests for preparing solar cells including an electrode layer, an active layer, and a transparent electrode layer with respect to the Comparative Examples 3 and 4 and the Inventive Examples 3 and 4, and then measuring photo-conversion efficiency values of CIGS solar cells and photo-conversion efficiency values of a-Si solar cells.

**[Table 1]**

| Classification | Types(substrate/diffusion barrier layer) | Diffusion barrier layer thickness (nm) | Solar cell photo-conversion efficiency (%) | |
|---|---|---|---|---|
| | | | CIGS | a-Si |
| Comparative Example 3 | Glass substrate | - | 15.47 | 7.22 |
| Comparative Example 4 | STS/SiO₂ | 1000 | 12.75 | 5.8 |
| Inventive Example 5 | STS/SiO₂/Mo | 520(500/20) | 13.39 | 6.22 |
| Inventive Example 6 | STS/SiO₂/Mo/SiO₂/Mo | 500(200/100/200/100) | 14.25 | 7.04 |

As illustrated in Table 1, Comparative Example 3 is an example in which a solar cell is embodied on the glass substrate, wherein measured photo-conversion efficiency values of the CIGS solar cell and the a-Si solar cell were 15.47% and 7.22% respectively. Further, Comparative Example 4 is an example in which Si02 was deposited to a thickness of 1000 nm, wherein photo-conversion efficiency values of the CIGS solar cell and the a-Si solar cell were 12.75% and 5.8% respectively. Furthermore, diffusion barrier layers of multilayered structures are included in Inventive Examples 5 and 6, wherein the multilayered structures are easily embodied in Inventive Examples 5 and 6 since deposition is progressed continuously in a roll-to-roll continuous process to which a metal substrate such as STS has been applied although deposition should be progressed several timers in the deposition process when applying the multilayered structures during an ordinary batch type deposition process. Further, a plurality of deposition sources are required to perform deposition to a wanted thickness since a deposition rate of 1 m/min or lower is generally quite slow. Therefore, various advantages of reducing the overall thickness as described in the above-mentioned Examples are existed when realizing a multilayered structure by installing a plurality of sources to deposit multiple materials rather than installing a plurality of sources to deposit a single material. In addition, measured photo-conversion values of the CIGS solar cells were 13.39% and 14.25% respectively and measured photo-conversion values of the a-Si solar cell were 6.22% and 7.04% respectively also in Inventive Examples 5 and 6.

While the present invention has been shown and described in connection with the exemplary embodiments, it will be apparent to those skilled in the art that modifications and variations can be made without departing from the spirit and scope of the invention as defined by the appended claims.

## Claims

1. A solar cell substrate comprising:
a lower substrate;
a lower electrode disposed on top of the lower substrate; and
a metal diffusion barrier layer including one or more metal layers between the lower substrate and the lower electrode, wherein the metal layers brought into contact with each other may be of different metals when the metal diffusion barrier layer includes two or more metal layers.

2. The solar cell substrate of claim 1, wherein the one or more metal layers of the diffusion barrier layer contain Na.

3. The solar cell substrate of claim 2, wherein the Na is contained in the metal layer brought into contact with the lower electrode.

4. The solar cell substrate of claim 2, wherein a content of the Na is in the range of 0.0005% to 0.1% by weight.

5. The solar cell substrate of claim 1, wherein the diffusion barrier layer including two or more metal layers further comprises an oxide layer between the at least two or more metal layers.

6. The solar cell substrate of claim 5, wherein the oxide layer is formed of any one of SiOx, SiNₓ, and Al₂O₃.

7. The solar cell substrate of claim 1, wherein the two or more metal layers are of metal materials different from each other.

8. The solar cell substrate of claim 1, wherein the metal is any one of Cr, Ti, Ni, and Mo.

9. The solar cell substrate of claim 1, wherein the diffusion barrier layer has a thickness of 100 to 500 nm, and, when the diffusion barrier layer includes two or more metal layers, each of the metal layers has a thickness of 10 nm or more.

10. The solar cell substrate of claim 1, wherein the lower substrate is one selected from the group consisting of glass, stainless steel, aluminum foil, Fe-Ni based metal, Fe-Cu based metal, and polyimide.

11. A solar cell comprising:
a solar cell substrate comprising a lower substrate, a lower electrode disposed on top of the lower substrate, and a metal diffusion barrier layer including one or more metal layers formed between the lower substrate and the lower electrode, wherein the metal layers brought into contact with each other may be of different metals when the metal diffusion barrier layer includes two or more metal layers;
a p-type light absorbing layer disposed on the solar cell substrate;
an n-type buffer layer disposed on the light absorbing layer;
a transparent window disposed on the buffer layer; and
an upper electrode disposed on the transparent window.

12. The solar cell of claim 11, wherein the one or more metal layers of the diffusion barrier layer contain Na.

13. The solar cell of claim 12, wherein the diffusion barrier layer including two or more metal layers further comprises an oxide layer between the two or more metal layers.

14. The solar cell of claim 13, wherein the oxide layer is formed of any one of SiOx, SiNₓ, and Al₂O₃,

15. The solar cell of claim 11, wherein the light absorbing layer includes CIGS, the buffer layer as an n-type semiconductor includes CdS, and the transparent window includes ZnO.

16. A method for manufacturing a solar cell substrate, the method comprising:
dispersing Na-containing metal particles into an electrolyte for electroplating; and
preparing a diffusion barrier layer by electroplating a lower substrate using the electrolyte in which the Na-containing metal particles are dispersed and forming a metal layer containing Na on the lower substrate.

17. The method of claim 16, wherein the Na-containing metal particles are sodium oxide (NaO₂).

18. The method of claim 17, wherein the sodium oxide (NaO₂) has a particle diameter of 10 to 100 nm.

19. The method of claim 17, wherein the dispersed sodium oxide has a particle concentration of 0.1 to 100 g/L.

20. The method of claim 16, wherein the electroplating process comprises:
dissolving salts of metals to be plated such that the salts of metal have a metal ion concentration of 1 to 100 g/L;
heating a plating bath in which the Na-containing metal particles are dispersed, such that the plating bath reaches a temperature of 50 to 60 °C, and performing a plating operation by applying a current with the current density of 0.1 to 100 A/dm² to the plating bath.
